# EUROPEAN PATENT APPLICATION

(11) **EP 2 477 019 A1**
(43) Date of publication of application: **18.07.2012**
(21) Application number: 11151043.4
(22) Date of filing: 14.01.2011
(51) Int. Cl.: G01L 9/00, H01L 29/778

(54) **Harsh environment pressure sensor**

(71) Applicant: Honeywell International Inc., Morristown, NJ 07962 (US)
(72) Inventor: Dumitru, Viorel-Georgel, 100077, Prahova (RO); Costea, Stefan-Dan, 041444, Bucharest (RO); Brezeanu, Mihai, 061397, Bucharest (RO); Serban, Bogdan-Catalin, 600000, Bucharest (RO)
(74) Representative: Fox-Male, Nicholas Vincent Humbert

(57) **Abstract**

A sensor for measuring pressures in harsh environments. The sensor may have transistors formed on a substrate. Formed from a portion of the substrate may be a diaphragm which can flex due to pressure changes on the diaphragm. The transistors may detect the flexing of the diaphragm and through a non-Wheatstone differential amplifier type circuit the transistors can indicate a magnitude of the pressure changes. The transistors may be high-electron-mobility transistors (HEMTs). The HEMTs may be III-nitride transistors. A wafer may be attached to the diaphragm to form a sealed cavity.

## Description

### Background

The present disclosure pertains to sensors and particularly to pressure sensors. More particularly, the sensor pertains to pressure sensors in harsh environments.

### Summary

The disclosure reveals a sensor for measuring pressures in harsh environments. The sensor may have transistors formed on a substrate. Formed from a portion of the substrate may be a diaphragm which can flex due to pressure changes on the diaphragm. The transistors may detect the flexing of the diaphragm and through a non-Wheatstone differential amplifier type circuit the transistors can indicate a magnitude of the pressure changes. The transistors may be high-electron-mobility transistors (HEMTs). The HEMTs may be III-nitride transistors. A wafer may be attached to the diaphragm to form a sealed cavity.

### Brief Description of the Drawing

Figure 1 is a diagram of a GaN transistor;
Figure 2a is a schematic of an illustrative example of an electronic circuit which integrates transistors as a basis for a pressure sensor;
Figure 2b is diagram of an illustrative example of a sensor having a substrate for containing transistors with the substrate having a membrane for detection of pressure; and
Figure 3 is a diagram of an illustrative example of a sensor having a substrate for containing transistors and having a cavity for detection of pressure relative to a reference pressure within the cavity.

### Description

Pressure sensors, able to work at high temperature and in harsh environments, appear to be needed in many application areas such as internal combustion engine measurements (in-cylinder pressure, exhaust, and so on), oil, gas and geothermal explorations and drilling, gas turbines and utility application (boilers, life safety, and so forth). In many cases, the required high operating temperatures (above 300 degrees C.) and the presence of corrosive media may impose drastic limitations on the sensor materials. For instance, commercially available silicon piezoresistive pressure sensors are often unable to work at such high temperatures.

An approach herein is to realize a GaN pressure sensor that uses for sensing gallium nitride (GaN) high electron mobility transistors (HEMTs) connected in an active load differential amplifier stage. GaN may be suitable for devices operating at high temperature and harsh environments applications. Due to its wide bandgap nature, GaN appears highly thermally stable. Thus, GaN electronic devices may be operated at elevated temperatures. The material appears also to be chemically stable making it suitable for operation in chemically harsh environments.

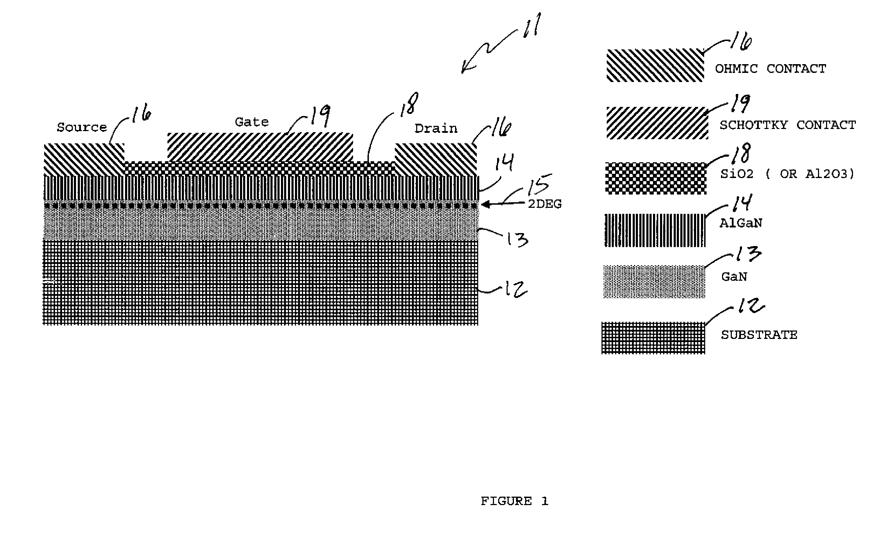

Figure 1 is a diagram of a GaN transistor 11 which may be used in the present sensor. A substrate 12 from a material such as silicon, sapphire or silicon carbide may be used. A layer 13 of GaN may be formed on substrate 12.

A layer 14 of AlGaN may be formed on layer 13. A 2-DEG (i.e., two-dimensional electron gas) 15 exists at an interface of layers 13 and 14. Contacts 16 may be formed on layer 14 for the drain and source. On at least a portion of the remaining surface of layer 14, a layer 18 of SiO₂ or Al₂O₃ may be formed. A contact 19 for a gate may be formed on layer 18. Drain or contact 16 and source or contact 16 may be regarded as ohmic contacts. Gate or contact 19 may be regarded as a Schottky contact.

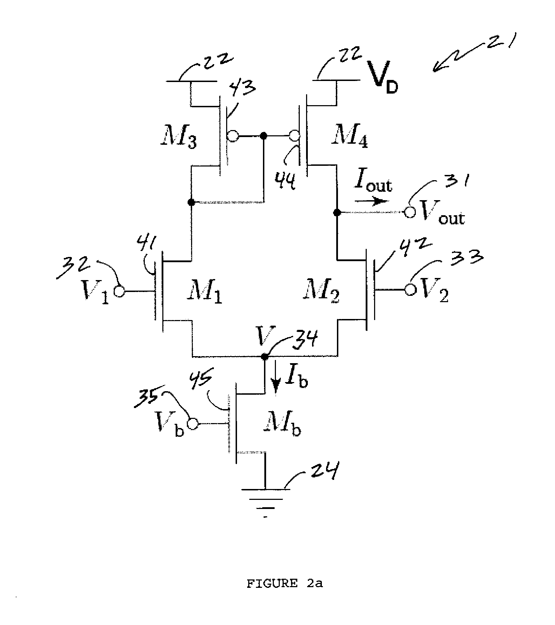

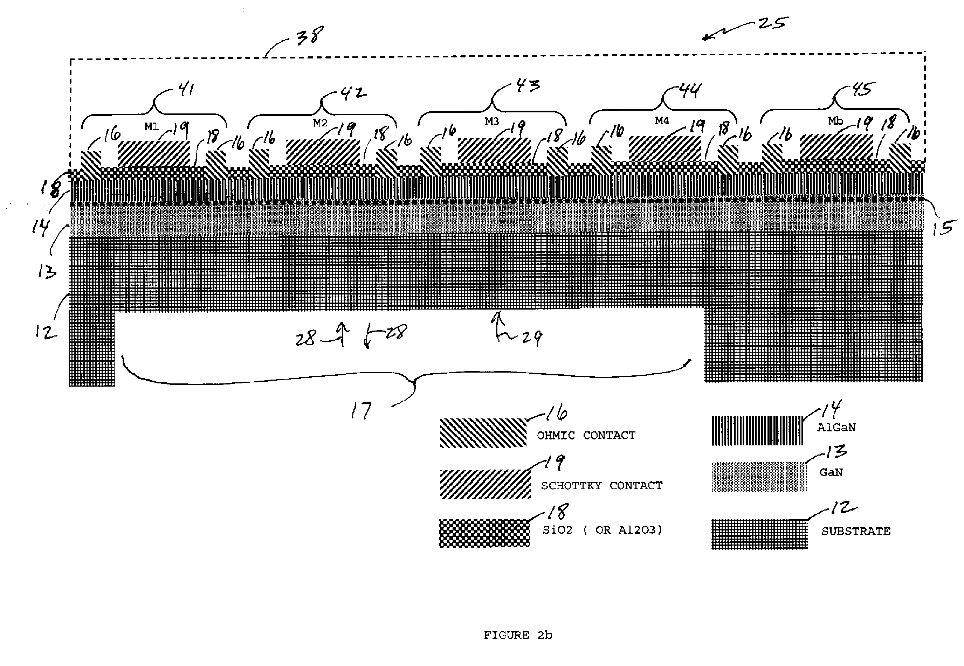

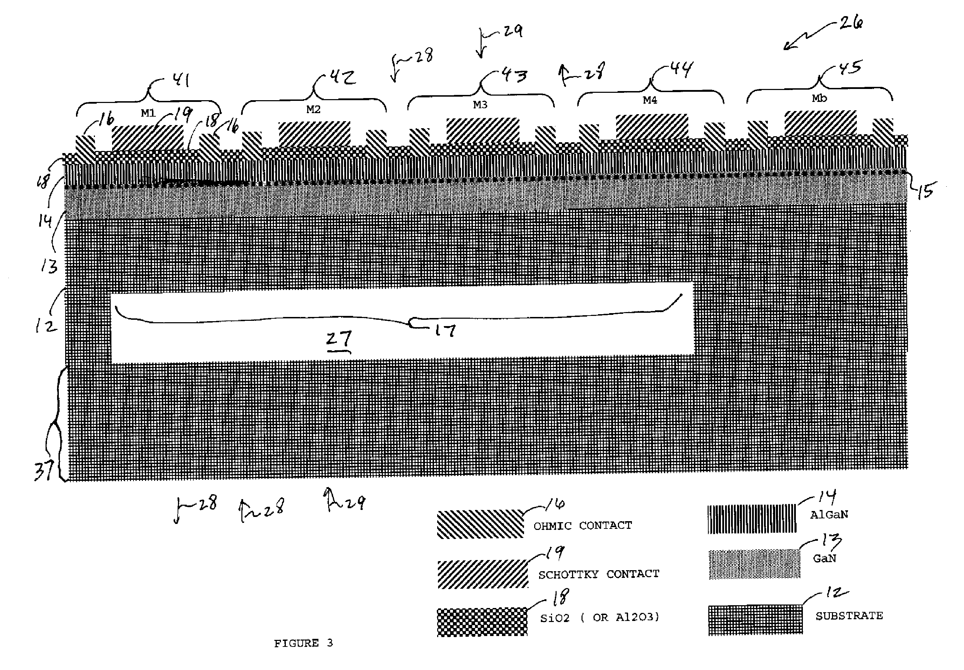

The present pressure sensor may consist of an electronic circuit built with several GaN HEMTs. One example of such a pressure sensor is shown in diagrams in Figures 2a and 2b. Structure and composition of transistors 41, 42, 43, 44 and 45, in the sensors of Figure2b and 3, may be similar to that of transistor 11 in Figure 1. The electronic circuit may be built with several GaN HEMTs as shown in a schematic of Figure 2a.

Figure 2a is the schematic of a circuit 21 which makes up a basis for the present pressure sensor. A transistor 43 (M3) may have a source for connection to a voltage (V_{D}) at a terminal 22. Another transistor 44 (M4) may have a source connected to terminal 22. The gates of transistors 43 and 44 may be connected together, and connected to a drain of transistor 43. The drain of transistor 43 may be connected to a source of a transistor 41 (M1). A drain of transistor 44 may be connected to a source of a transistor 42 (M2). The drains of transistors 41 and 42 may be connected to a connection 34 which is connected to a source of a transistor 45 (Mb). Transistor 45 may have a drain for connection to a ground or reference voltage terminal 24. A current (Ib) may flow from the drains of transistors 41 and 42 via the connection 34 to and through transistor 45 to terminal 24. A voltage (V) may be indicated at connection 34. A current (Iout) and a voltage (Vout) output may be at a terminal 31. Terminal 31 may be connected to the drain of transistor 44 and the source of transistor 42. A gate of transistor 41 may be for connection to a first voltage (V1) at a terminal 32. A gate of transistor 42 may be for connection to a second voltage (V2) at a terminal 33. A gate of transistor 45 may be for connection to a voltage (Vb) at a terminal 35.

The circuit may be at least partially located on a flexible membrane 17 which might be a result of an etched portion from substrate 12 of a sensor 25, as shown in Figure 2b. The membrane 17 may bend under pressure 29 stress in directions 28. Directions 28 may be approximately perpendicular to a major surface of membrane 17, substrate 12, and/or layers of sensor 25. Pressure 29 may provide stress or strain to the membrane 17. It may be noted that in the membrane, the stress/strain may also occur laterally due to deformation.

The surface of substrate 12, opposite of the surface of the diaphragm 17, which is exposed to pressure 29, may have an optional cap 38 sealing that surface of substrate 12 or other mechanism for isolating that surface or side of substrate 12 from the environment and effects of pressure 29, thereby preventing a reduction or offsetting the pressure 29 impinging diaphragm 17 from the other side of the diaphragm. The transistors may be on the surface covered by cap 38.

The associated stress or strain may modify a piezoelectric polarization and thus change the 2-DEG concentration 15 in the channel of transistors 41 (M1), 42 (M2), 43 (M3) and 44 (M4). Thus, the channel conductance of the four HEMTs 41 (M1), 42 (M2), 43 (M3) and 44 (M4) may change with the measured pressure. An amount of channel conductance change in one or more of the four HEMTs may be a measurement of pressure 29. It should be noted that by positioning HEMTs 42 (M2) and 43 (M3) near the center of the flexible membrane 17 and HEMTs 41 (M1) and 44 (M4) near the edges of membrane 17, the sign or direction of the changes may be the opposite for the two pairs of transistors. When the channel conductivity of HEMT 42 (M2) and HEMT 43 (M3) increases, then the channel conductivity of HEMT41 (M1) and HEMT 44 (M4) may decrease, and vice versa). By not being situated over or on flexible membrane 17, although situated on substrate 12, a GaN HEMT 45 (Mb) is not necessarily influenced by an ambient pressure change. Transistor 45 may be a reference of non-change in substrate 12 flexibility. The five transistors 41, 42, 43, 44 and 45 may be connected in an active load differential amplifier stage (Figure 2a), where the output signal Vₒᵤₜ at terminal 31 is proportional to a magnitude of detected pressure 29. The unbalance between the transistor 41/43 (M1/M3) branch and the transistor 42/44 (M2/M4) branch may be increased by opposite effects of the pressure on the transistor 41/44 (M1/M4) pair and the transistor 42/43 (M2/M3) pair, respectively. The output signal at terminal 31 may be further processed by amplifier stages designed specifically for impedance matching and noise reduction. Such processing may result in more accurate measurements of pressure 29. One or more of the transistors 41-45 may be of another kind other than an HEMT.

Figure 3 is a diagram of a sensor 26 which is a version of the pressure sensor 25 shown in Figure 2b. The flexible membrane 17 may form one sidewall and sides perpendicular to the sidewall of an enclosed cavity 27. A wafer 37 may be attached to the membrane to form the other sidewall of cavity 27. The sensor 26 shown in Figure 3 may measure external pressure relative to or against a reference pressure within the enclosed cavity 27.

In some instances of GaN HEMT pressure sensors, the pressure may be sensed by channel resistivity change in one or more HEMTs or in four HEMTs connected together in a Wheatstone bridge configuration. However, in the present instance, the sensing may be performed by each individual transistor 41 (M1), 42 (M2), 43 (M3) and 44 (M4). The transistors may be connected in an electronic circuit configuration which is different from a Wheatstone configuration. An improvement in sensitivity may primarily be due to a differential configuration of the electronic circuit. However, advantages of a Wheatstone bridge may be preserved, by using an opposite effect that pressure 29 has on the transistor pairs 41/44 (M1/M4) and 42/43 (M2/M3), respectively, thus doubling an effect of pressure 29 on the output signal Vout at terminal 31. Additionally, the transistors may be biased (using V1, V2, Vb and VD at terminals 32, 33, 35 and 22, respectively) in a manner so that circuit sensitivity to pressure 29 is optimized. The active load differential circuit configuration may also be very efficient in removing the common mode effects, via a current mirror built with transistors 43 (M3) and 44 (M4). The performance of sensors 25 and 26 may be improved by reducing the cross-sensitivities (e.g., temperature, humidity, or the like) that are likely to equally affect virtually all of the transistors.

One may return to the example of a GaN HEMT structure 11 of Figure 1 that can be used in the present sensors 25 and 26. Due to the presence of dielectric layer 18 (such as SiO₂, Al₂O₃, and the like) which may act also as a passivation layer under the gate 19 metallization, structure 11 may be regarded as a metal-insulator-semiconductor (MIS) HEMT.

The transistor 11 operation may be based on an existence of a 2-DEG (two-dimensional electron gas) 15 at the AlGaN/GaN interface. The 2-DEG 15 may be created by strong piezoelectric and spontaneous polarization effects in the heterostructure, and by surface states and a large conduction band offset.

While Figure 1 shows an AlGaN/GaN HEMT, virtually any other GaN-based HEMT structure, such as Al InN/GaN, AlInGaN/GaN, AlGaN/InGaN, and so on, may be used. The GaN HEMT structure may incorporate, as well, a buffer layer, a cap layer and other layers of the GaN HEMT technology, which are not necessarily shown in Figure 1.

The surface and interface charges induced by spontaneous and piezoelectric polarization may be used for the detection of pressure changes.

For obtaining the present pressure sensor 25 or 26, it may be necessary to provide an electronic circuit based on GaN HEMTs transistors and place it proximate to or over diaphragm 17 on the substrate 12 side, as shown in Figures 2b and 3. The electronic circuit may be built on-chip by connecting the five or so GaN HEMTs accordingly in view of the schematic of Figure 2a. For fabricating the GaN HEMTs transistors, various process and fabrication technologies of GaN HEMT transistors may be used.

As for substrate 12, SiC, sapphire or silicon may be used. Virtually all of the substrates being normally used for epitaxial growing may be incorporated for GaN HEMT structures. For realizing electrical contacts, various general and specific metallization schemas (like Ti/Al/Au, Ti/Al/Ti/Au or Ti/Al/Ni/Au for the source and drain ohmic contacts 16, and Ni/Au, Pt/Au or Pd/Au for the gate Schottky contacts 19) and annealing processes may be used. Specific metallization schema and annealing processes for realizing ohmic and Schottky contacts for a GaN HEMT may be used.

The circuit interconnection (connections between the GaN HEMTs accordingly to Figure 2a) may be fabricated by various techniques (e.g., photolithograpy, and so forth) using Au, Ni/Au or Cr/Au metalizations.

Further, diaphragm 17 may be obtained by etching substrate 12 using various techniques (e.g., like wet or dry etching in case of silicon), or other techniques such as those used in the case of sapphire and SiC substrates.

For obtaining the sensor 26 structure with an enclosed cavity 27 shown in Figure 3, the structure described in Figure 2b may furthermore be completed by covering the flexible membrane 17 with a cover wafer 37 from the same material and attaching the membrane and the wafer together so as to form the sealed cavity 27.

In the present specification, some of the matter may be of a hypothetical or prophetic nature although stated in another manner or tense.

Although the present system has been described with respect to at least one illustrative example, many variations and modifications will become apparent to those skilled in the art upon reading the specification. It is therefore the intention that the appended claims be interpreted as broadly as possible in view of the prior art to include all such variations and modifications.

## Claims

1. A pressure sensor comprising:
a substrate;
two or more transistors situated on a first surface of the substrate;
a circuit interconnecting the two or more transistors; and
a membrane formed of at least a portion of the substrate on a second surface of the substrate; and
wherein:
the membrane has a change in shape when a pressure is applied to the membrane;
the two or more transistors provide a detection of the change in shape of the membrane; and
the circuit converts the detection into an indication of a magnitude of the pressure; and
the two or more transistors are high-electron-mobility transistors.

2. The sensor of claim 1, wherein:
the high-electron-mobility transistors comprise a III-nitride structure; and
the high-mobility-electron transistor having a III-nitride HEMT structure comprises AlGaN/GaN, AlInN/GaN, AlInGaN/GaN, AlGaN/InGaN, or other like material arrangement.

3. The sensor of claim 1, wherein the circuit interconnecting the two or more transistors, comprises:
a first transistor having a gate connected to a first voltage terminal;
a second transistor having a gate connected to a second voltage terminal;
a third transistor having a source connected to a third voltage terminal; and
a fourth transistor having a source connected to a fourth voltage terminal; and wherein:
a drain of the first transistor is connected to a drain of the second transistor;
a drain and a gate of the third transistor are connected to a source of the first transistor;
a gate of the fourth transistor is connected to the gate of the third transistor; and
a drain of the fourth transistor is connected to a source of the second transistor.

4. The sensor of claim 3, further comprising:
a fifth transistor having a source connected to the drains of the first and second transistors; and
wherein:
the third and fourth voltage terminals are connected together;
a gate of the fifth transistor is connected to a fifth voltage; and
a drain of the fifth transistor is connected to a reference voltage.

5. The sensor of claim 4, wherein the first, second, third and/or fourth transistor has a change in conductivity of a channel from the change in shape of the diaphragm which provides the detection of the change in shape of the membrane.

6. The sensor of claim 1, further comprising:
a wafer attached to the membrane to form a closed cavity having a surface of the membrane and a surface of the wafer; and
wherein the membrane changes in shape in response to pressure applied to the first surface of the substrate.

7. A harsh environment pressure sensor comprising:
a substrate having a flexible diaphragm; and
one or more transistors situated on the substrate for detecting flexing of the diaphragm; and wherein:
the flexing of the diaphragm is from a pressure of a medium impinging the diaphragm; and
the one or more transistors are high-electron-mobility transistors.

8. The sensor of claim 7, wherein the high-electron-mobility transistors comprise a III-nitride structure.

9. The sensor of claim 7, wherein:
four transistors of the one or more transistors are connected in an active load differential amplifier and non-Wheatstone configuration circuit; and
the circuit provides an electrical output indicating a magnitude of pressure of the medium impinging the diaphragm.

10. The sensor of claim 7, wherein the surface of the substrate on an opposite side of a surface of the diaphragm subject to a pressure of the medium impinging the diaphragm is isolated from the pressure of the medium impinging the diaphragm.

11. The sensor of claim 7, wherein the flexing of the diaphragm affects a two-dimensional electron gas concentration in a channel and conductance of the channel of a respective transistor to result in a signal from the transistor indicating a magnitude of the flexing of the diaphragm.

12. The sensor of claim 9, wherein:
two or more of transistors are situated at positions on the substrate proximate to a center of the diaphragm; and
two or more transistors are situated at positions on the substrate proximate to one or more edges of the diaphragm.

13. The sensor of claim 10, further comprising a cap formed on the surface of the substrate on the opposite side of the surface of the diaphragm subject to a pressure of the medium impinging the diaphragm.

14. A pressure sensor comprising:
a substrate; and
a sensing element situated on the substrate; and
wherein:
the substrate is etched to form a flexible diaphragm; and
the sensing element comprises at least four III-nitride high-electron-mobility transistors connected in a non-Wheatstone electronic circuit.

15. The pressure sensor of claim 14, wherein:
the electronic circuit is an active load differential amplifier; and
the flexible diaphragm forms one sidewall of an enclosed cavity.
